# EUROPÄISCHE PATENTSCHRIFT

(11) **EP 1 659 411 B1**
(45) Veröffentlichungstag und Bekanntmachung des Hinweises auf die Patenterteilung: **23.01.2008**
(21) Anmeldenummer: 05017361.6
(22) Anmeldetag: 10.08.2005
(51) Int. Cl.: G01R 11/04

(54) **Elektronischer Elektrizitätszähler**
Electronic electricity meter
Compteur d'électricité électronique

(30) Priorität: 18.11.2004 DE 202004017886 U
(43) Veröffentlichungstag der Anmeldung: 24.05.2006
(73) Patentinhaber: EMH Elektrizitätszähler GmbH & Co KG, 19243 Wittenburg (DE)
(72) Erfinder: Glomski, Mark, 21035 Hamburg (DE)
(74) Vertreter: Hauck Patent- und Rechtsanwälte

(56) Entgegenhaltungen:
- EP-A- 1 431 765
- DE-U1-8202004 000 85
- US-A- 5 966 010
- US-A- 6 008 711
- US-A1- 2002 084 778

## Beschreibung

Die Erfindung bezieht sich auf einen elektronischen Elektrizitätszähler nach dem Oberbegriff des Anspruchs 1.

Herkömmliche Elektrizitätszähler weisen den Nachteil auf, dass die Stromzufuhr zum Versorger unterbrochen ist, wenn der Zähler repariert oder ausgetauscht wird. Es ist daher auch bereits bekannt geworden, einen derartigen Zähler zweiteilig auszubilden, in der Weise, dass eine Plattform, die mit Anschlussmöglichkeiten für die Versorgungsleitungen versehen ist, ständig am Anbringungsort verbleibt, während ein Gehäuse, das alle Komponenten und Bauteile eines elektronischen Elektrizitätszählers enthält, lösbar mit der Plattform verbindbar ist. Die mechanische Verbindung geschieht zum Beispiel mit Hilfe von hakenartigen Vorsprüngen, welche in entsprechende Ausnehmungen der Plattform eingreifen. Es findet dabei vorzugsweise eine Verhakung zwischen den Teilen statt, und ein Plombierelement, dass sich durch das Gehäuse bis zur Plattform erstreckt, verriegelt das Gehäuse einer Plattform (das Plombierelement wird seinerseits mit Hilfe einer Plombe gesichert). Die Verriegelung kann nur aufgehoben werden, wenn das Plombierelement gelöst wird, was wiederum nur durch Beschädigung der Plombe geschehen kann. Diese Anordnung hat den Vorteil, dass bei Lösen des Gehäuses von der Zählerplattform die Verbindung zum Versorger nicht unterbrochen ist und keine gefährlichen Arbeiten unter Spannung durchgeführt werden müssen. Ein Zähleraustausch lässt sich innerhalb kürzester Zeit bewerkstelligen, so dass für den Energieversorger Verluste nicht entstehen. Die Zählerplattform ist entweder für sich an einer Wand eines Zählerschranks angebracht oder befindet sich innerhalb eines Zählergehäuses oder ist Teil der Wand des Zählergehäuses. Ein derartiger Zähler ist beispielsweise aus der Gebrauchsmusterschrift DE 202 004 000 858 U1 bekannt.

Die Erfindung geht von einem derartigen zweigeteilten Elektrizitätszähler aus und hat sich die Aufgabe gestellt, den inneren Aufbau des Gehäuses für den Elektrizitätszähler einfach und einfach montierbar zu gestalten.

Diese Aufgabe wird durch die Merkmale des Patentanspruchs 1 gelöst.

Ein Gehäuse, wie es bei einem derartigen Elektrizitätszähler zweckmäßig ist, ist üblicherweise aus mindestens zwei Teilen, vorzugsweise aus Kunststoffmaterial, hergestellt, nämlich einem kastenförmigen Unterteil und einem Deckel oder einer Haube, die miteinander in geeigneter Weise verbunden werden. Erfindungsgemäß ist nun ein Haltebauteil vorgesehen, dass skelettartig geformt ist, und alle Teile und Komponenten, die für einen elektronischen Elektrizitätszähler erforderlich bzw. vorgesehen sind, sind sinnreich an dem Haltebauteil angebracht. So weist das erfindungsgemäße Haltebauteil auf der dem Boden des Gehäuses zugewandten Seite drei Fassungen auf, die Stromsensoren, insbesondere blockförmige Kapselungen der Stromwandler aufnehmen, vorzugsweise klemmend. Ferner sind am Haltebauteil in Schlitzabschnitten relativ steife Leiterschleifen aufgenommen, die sich einerseits durch die Stromsensoren bzw. Stromwandler erstrecken und zum anderen durch Schlitze im Boden des Gehäuses zur Verbindung mit Kontakten in der Zählerplattform. Ferner weist das Haltebauteil auf der dem Boden gegenüberliegenden Seite Rastmittel auf zum lösbaren Festlegen der Leiterplatte annähernd parallel zum Boden und zum Deckenabschnitt des Gehäuses.

Das erfindungsgemäße Haltebauteil kann vor dem Einsetzen in das Gehäuse mit allen Komponenten und Teilen ausgestattet werden. Die Anbringung dieser Komponenten und Teile an dem Haltebauteil ist äußerst einfach. Es brauchen lediglich Schnappverbindungen oder klemmende Anbringungsmöglichkeiten vorgesehen zu werden. Ein Verschrauben, Verschweißen oder ein sonstiges aufwendiges Festlegen ist nicht erforderlich. Die Leiterplatte, die zuvor fertig bestückt ist, braucht lediglich auf das Haltebauteil aufgeklippst zu werden. Die Entfernung der Leiterplatte ist daher ebenfalls auf einfache Weise zu bewerkstelligen.

Da die elektrische Verbindung zwischen Leiterteilen im Gehäuse und Kontakten in der Zählerplattform automatisch herbeigeführt sein muss, wenn das Gehäuse auf die Zählerplattform aufgebracht wird, ist eine relativ präzise Anordnung der Leiterteile im Gehäuse erforderlich. Hierzu gehört jedoch auch, dass das Haltebauteil im Hinblick auf das Gehäuse eine relativ exakte Lage einnimmt. Zu diesem Zweck sieht eine Ausgestaltung der Erfindung vor, dass an der Innenseite von gegenüberliegenden Seitenwänden des Gehäuses erste Rastmittel und an gegenüberliegende Enden des Haltebauteils zweite Rastmittel angeformt sind und erste und zweite Rastmittel das Haltebauteil fest gegenüber dem Boden und den Seitenwänden verriegeln. Kanalartige Führungen an gegenüberliegenden Enden des Gehäuses können mit Endabschnitten des Haltebauteils zusammenwirken, um es beim Einsetzen in das Gehäuse sicher zu führen und gleichzeitig eine Lagesicherung zu bewerkstelligen.

Vorzugsweise sind U-förmige Leiterschleifen vorgesehen, die vorzugsweise aus relativ flachem Material, insbesondere aus Kupfer, geformt sind, wobei ein Schenkel einer U-förmigen Leiterschleife durch jeweils einen Stromsensor bzw. Stromwandler erstreckt ist. Nach einer anderen Ausgestaltung der Erfindung können am Boden des Gehäuses wandartige Vorsprünge geformt werden, die jeweils mit der Unterseite des Steges einer U-förmigen Leiterschleife zusammenwirken, um eine lagerichtige Anordnung der Schenkel in Bezug auf die Zählerplattform herbeizuführen. Bei einer weiteren Ausgestaltung der Erfindung sind an den U-förmigen Leiterschleifen jeweils Zungen angeformt, die zur Spannungsmessung in Berührung mit Kontakten der Leiterplatte stehen. Vorzugsweise erstreckt sich jeweils eine Zunge durch eine Öffnung in der Leiterplatte, in welcher ein entsprechender Kontakt vorgesehen ist.

Die Leiterplatte ist nach einer weiteren Ausgestaltung der Erfindung an Auflageflächen oder Abstützflächen des Haltebauteils abgestützt und mit Hilfe von Rastnasen, die an flexiblen Armen des Haltebauteils angeformt sind, an dem Haltebauteil verriegelt. Dadurch, dass die flexiblen Arme in Ausnehmungen der Leiterplatte eingreifen, ist diese im Hinblick auf ihre Relativlage zum Haltebauteil ebenfalls festgelegt.

Erfindungsgemäß kann um das Haltebauteil auch eine magnetische Abschirmung herumgelegt und festgelegt werden, um eine Störung des Stromsensors durch magnetische Felder zu vermeiden.

Die Erfindung wird nachfolgend anhand eines in Zeichnungen dargestellten Ausführungsbeispiels näher erläutert.
- Fig. 1: zeigt in auseinandergezogener Bauweise perspektivisch das Gehäuse und ein Haltebauteil eines erfindungsgemäßen Elektrizitätszähler.
- Fig. 2: zeigt die Anordnung von U-förmigen Leiterschleifen für den Elektrizitätszähler nach Fig. 1.
- Fig. 3: zeigt perspektivisch das Haltebauteil für den Elektrizitätszähler nach Fig. 1.
- Fig. 4: zeigt die Anordnung von drei Stromwandlern für den Elektrizitätszähler nach Fig. 1.
- Fig. 5: zeigt den Einbau der Stromwandler und der Leiterschleifen nach Fign. 2 und 4 in das Haltebauteil nach Fig. 3.
- Fig. 6: zeigt perspektivisch das Haltebauteil nach Fig. 3 mit einer magnetischen Abschirmung.
- Fig. 7: zeigt die gleiche Anordnung wie Fig. 6, jedoch in um 180° gedrehter Darstellung.

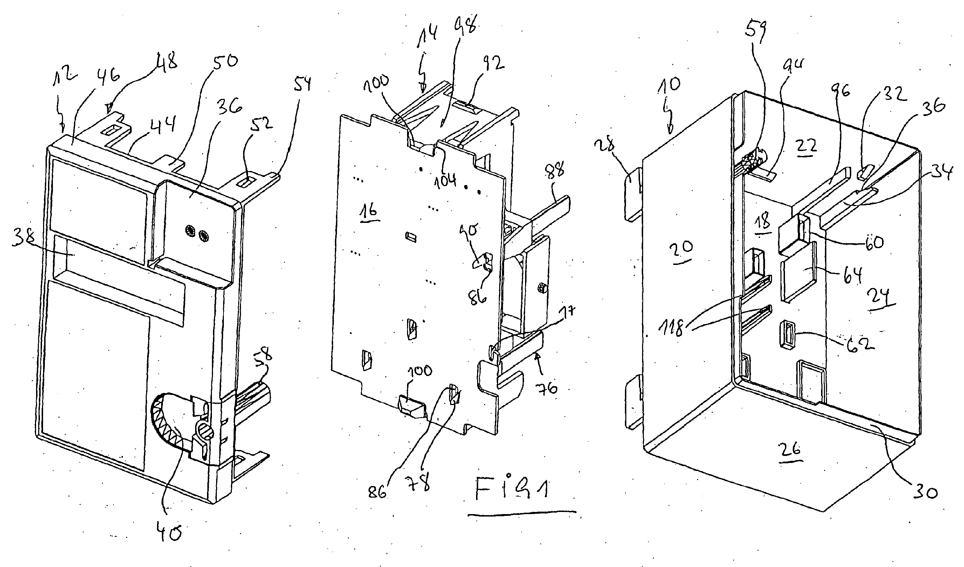

In Fig. 1 ist ein kastenartiges Unterteil 10 zu erkennen, dessen obere Öffnung durch einen haubenartigen Deckel 12 verschließbar ist. Das auf diese Weise gebildete Gehäuse nimmt ein Haltebauteil 14 auf, an dem unter anderem eine Leiterplatte 16 angebracht ist. Von dieser ist lediglich die Platte selbst gezeigt ohne die einzelnen Bauteile und Komponenten, mit der sie zur Verwirklichung eines Elektrizitätszählers bestückt werden kann.

Das Unterteil 10 weist einen Boden 18 auf sowie vier Seitenwände 20, 22, 24, 26. Ausgerichtet zu den Längsseitenwänden 20, 24 sind außen am Boden 18 hakenartige Vorsprünge 28 geformt. In Fig. 1 sind die Vorsprünge 28 nur auf einer Seite zu erkennen. Sie dienen zum Einhaken des Unterteils 10 in entsprechenden Schlitzen einer nicht gezeigten Zählerplattform, die an einer Wand oder in einem Gehäuse angebracht und mit Anschlussmitteln für Versorgungsleitungen versehen ist. Die Seitenwände 20 bis 26 haben einen nahezu vollständig umlaufenden Steg 30 an der offenen Kante. Die Seitenwände 22, 26 haben Verriegelungsvorsprünge 32 (in Fig. 1 ist nur einer zu erkennen) sowie an einem leistenartigen Abschnitt 34 in den Ecken eine Verriegelungsfläche 36, auf deren Funktion weiter unten noch eingegangen wird.

Der Deckel 12 weist an dem Deckenabschnitt mehrere Einprägungen auf, wobei eine bei 36 zum Ansetzen eines Abfragegerätes für den Status des Elektrizitätszählers dient, ein Fenster 38 zum Betrachten eines Displays auf der Schaltplatine 16 und eine Ausnehmung 40 zum Einlegen der Plombe für das Plombierelement. Am Rand weist der Deckel zwei beabstandete schürzenartige Randabschnitte 44 bzw. 46 auf. Der äußere Randabschnitt 46 ist weniger breit als der innere Randabschnitt 44, und zwischen den Abschnitten 46, 44 ist ein Zwischenraum vorgesehen, in den der Steg 30 des Unterteils 10 eingreift, wenn der kappenartige Deckel 12 auf die Öffnung des Unterteils 10 aufgesetzt wird. In Verlängerung des inneren Randabschnitts 44 weist der Deckel 12 an den Ecken Beine 48 auf, die relativ flach ausgebildet sind und an gegenüberliegenden Enden des Deckels jeweils annähernd in einer Ebene liegen. Zwischen den Beinen 48 ist an den hinteren Rand 44 ein flacher Ansatz 50 geformt. Die Beine 48 weisen ein rechteckiges Loch 52 auf und einen Ansatz 54, der in Verlängerung der Beine 48 geformt ist. Beim Aufsetzen des Dekkels 12 auf das Unterteil 10 gleiten die Beine 48 an der Innenseite der Wandabschnitte 22, 26, und der Verriegelungsvorsprung 32 rastet in die Öffnungen oder Löcher 52 der Beine 48 ein, wobei die Beine 48 zunächst durch die rampenartige Fläche oberhalb der Verriegelungskante der Vorsprünge 32 etwas nach Innen im unteren Teil 10 abgelenkt werden. Der Ansatz 54 leitet dabei auf einer Rampenfläche oberhalb der Verriegelungsfläche 36 und wird dadurch nach außen in Richtung des zugekehrten Wandabschnitts 22, 26 ausgelenkt. Wenn der Verriegelungsvorsprung 32 in das Loch 52 eingerastet ist, liegt der Ansatz gegen die Verriegelungsfläche 36, so dass eine Manipulation am Deckel 12 nicht zu einem Lösen des Deckels bzw. der beschriebenen Verriegelung führt.

Am Deckel 12 ist ein hülsenförmiger Ansatz 58 angeformt, der sich annähernd bis zum Boden 18 des Unterteils 10 erstreckt, wo der Deckel 12 auf das Unterteil 10 aufgesetzt ist. Durch den Ansatz 58 wird ein Plombierstift 59 gesteckt, der durch ein Loch im Boden 18 (nicht gezeigt) hindurchgeführt ist und der mit dem der Zählerplattform zugekehrten Ende mit dieser verriegelnd zusammenwirkt, um das beschriebene Gehäuse bzw. das Unterteil 10 an der Plattform zu verriegeln. Das am Deckel befindliche Ende des Plombierstifts (nicht gezeigt) wird in geeigneter Weise mit einer Plombe versehen, so dass ein Entfernen des Unterteils 10 von der Zählerplattform nicht möglich ist, ohne die Plombe zu zerstören.

An dem Boden 18 sind kaminartige nach oben ragende Vorsprünge 60 geformt, die einen schlitzartigen Durchbruch durch den Boden 18 bilden. Insgesamt sind zwei derartige Vorsprünge 60 vorgesehen (einer ist wegen des Wandabschnittes 20 nicht zu erkennen) sowie ein weiterer in der Ecke zwischen den Wandabschnitten 20 und 26 in Fig. 1, der ebenfalls nicht dargestellt ist. Zwei stiftartige Vorsprünge 118 am Boden 18 dienen dem gleichen Zweck wie die Vorsprünge 60, nämlich der Begrenzung der U-förmigen Leiter in Richtung Boden 18 bzw. der Zählerplattform. Zu den Vorsprüngen 60 gehören niedrige Vorsprünge 62, die ebenfalls schlitzartige Durchbrüche aufweisen. Der Zweck der Vorsprünge 60, 62 bzw. 118 wird weiter unten erläutert. Schließlich ist in Fig. 1 zu erkennen, dass am Boden wandartige Vorsprünge 64 geformt sind. Es sind insgesamt zwei derartige Vorsprünge 64 vorgesehen von denen einer nur in Fig. 1 zu erkennen ist.

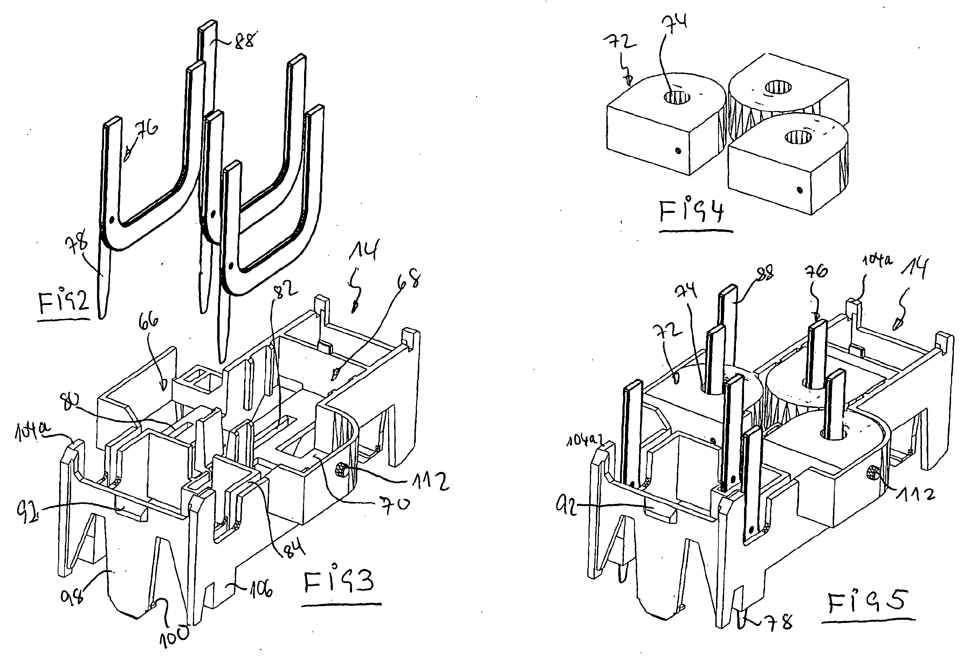

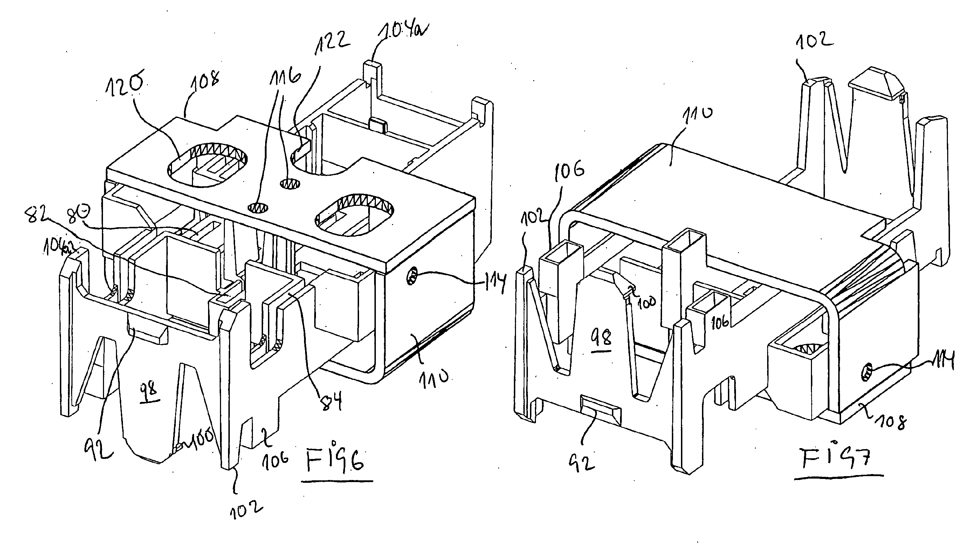

Nachfolgend wird das skelettartige Haltebauteil 14 näher anhand der Fign. 3 bis 5 bzw. 6 und 7 beschrieben. In den Fign. 3 und 5 ist die dem Boden 18 zugekehrte Seite des Haltebauteils 14 zu erkennen. Es weist drei Aufnahmeabschnitte 66, 68 und 70 auf. Sie dienen zur klemmenden Aufnahme von Stromwandlern 72, die in Isoliermaterial blockartig gekapselt sind, so dass sich abgeflachte halbkreisförmige Scheiben ergeben mit einem zylindrischen Durchgang 74. Der Durchgang 74 ist konzentrisch zur Wicklung der Stromwandler 72, die jedoch nicht zu erkennen ist. Wie sich aus Fig. 5 ergibt, können die Kapselungen der Stromwandler 72 klemmend in die Aufnahmeabschnitte 66 bis 70 eingesetzt werden, wobei ihre Oberseite mit den Außenkanten bzw. unteren Kanten des Haltebauteils 14 fluchten.

In Fig. 2 sind drei U-förmige Leiterschleifen 76 aus flachem Kupfermaterial dargestellt. An einen Schenkel der U-förmigen Leiterschleifen 76 ist auf der einen Seite eine Zunge 78 angebracht, die über den Steg der Leiterschleifen hinaus nach unten stehen. Wie in Fig. 5 zu erkennen, werden die Leiterschleifen mit einem Schenkel durch die Durchgänge 74 der Stromwandler 72 hindurchgesteckt. Die Stege der Leiterschleifen 76 werden von schlitzartigen Ausnehmungen 80, 82, 84 aufgenommen, welche die Tiefe des Einsetzens der U-förmigen Abschnitte 76 begrenzen. Dadurch ist die Lage der Enden der Leiterabschnitte 76, wenn sie im Haltebauteil 14 in der in Fig. 5 dargestellten Art und Weise aufgenommen sind, definiert. Die Fahnen 78 erstrecken sich durch entsprechende Schlitze im Haltebauteil 14 und aus diesem heraus (Fig. 5). Wie aus Fig. 1 zu erkennen, erstrecken sich die Fahnen durch Öffnungen 86 in der Leiterplatte 16 und kommen dort mit einem Kontakt in Berührung. Die freien Enden der U-förmigen Leiterabschnitte werden in Kontakt gebracht mit Kontakten der nicht gezeigten Zählerplattform und ermöglichen dadurch den Stromfluss aus den drei Phasen des Versorgungsnetzes durch die Stromwandler 72. Die Spannungsmessung erfolgt durch Abgriff an den Zungen 78 unmittelbar an der Leiterplatte 16. Ein viertes gerades Leiterstück aus dem gleichen Material wie die U-förmigen Leiterschleifen 76 ist in Fig. 2 bei 88 dargestellt und ist eine Verbindung auf dem N-Leiter des Versorgungsnetzes. Es weist ebenfalls eine Zunge 90 auf (Fig. 1). Es wird in ähnlicher Weise wie ein Schenkel der Leiterschleifen 76 vom Haltebauteil aufgenommen, wobei die Zunge 78 über eine Öffnung 86 in Kontakt gebracht wird mit einem Kontakt der Leiterplatte 16.

Das Haltebauteil 14 ist in seinem Umriss derart, dass es annähernd passend vom Unterteil 10 aufgenommen wird. An den schmaleren Enden weist es jeweils einen Verriegelungsvorsprung 92 auf. Die Vorsprünge 92 wirken mit Verriegelungsvorsprüngen 94 auf der Innenseite der Seitenwandabschnitte 22, 26 zusammen. Wird das Haltebauteil 14 in das Unterteil 10 eingesteckt und mit etwas Kraft gegen den Boden 18 gedrückt, greifen die Verriegelungsvorsprünge 92, 94 hintereinander, wodurch das Haltebauteil 14 gegen den Boden 18 festgelegt ist. Seitliche Bewegung wird begrenzt durch Führungen an der Innenseite der Wandabschnitte 22, 26, wobei bei 96 eine Leiste einer Führung dargestellt ist. Bei der beschriebenen Anbringung und Verriegelung des Haltebauteils 14 erstrecken sich die Schenkel der Leiterschleifen 76 durch die Durchbrüche der Vorsprünge 60 und 62. Dabei legt sich die Innenseite der Stege der Leiterschleifen 76 gegen die wandartigen Vorsprünge 64 und die Vorsprünge 118 an, wodurch sie in ihrer Höhe bzw. dem Ausmaß, mit dem sie über den Boden 18 überstehen, begrenzt werden.

An denselben Endabschnitten, an denen die Verriegelungsvorsprünge 92 angebracht sind, weist das Haltebauteil 14 flexible Arme 98 auf, die am freien Ende eine nach innen stehende Verriegelungsnase 100 haben. In den beschriebenen Eckbereichen des Haltebauteils sind auf der dem Deckel 12 zugewandten Seite jeweils vier Abstützflächen 102 geformt. Auf die Abstützflächen 102 wird die Leiterplatte 16 aufgelegt, wobei die Rastnasen 100 der flexiblen Arme 98 die Leiterplatte 16 übergreifen und dadurch am Haltebauteil 14 festlegen. Die Leiterplatte 16 weist in den Eingriffsbereichen eine Ausnehmung 104 auf, in welche jeweils ein Arm 98 nahe der Verriegelungsnase 100 annähernd passend eingreift. Dadurch ist die Leiterplatte 16 auch seitlich festgelegt. Der Umriss der Leiterplatte 16 ist dabei derart, dass er annähernd den Querschnitt des Unterteils 10 ausfüllt, wenn sie mit dem Haltebauteil 14 verriegelt in dem Unterteil 10 auf die beschriebene Art und Weise festgelegt ist. Die dem Boden 18 zugekehrte Seite des Haltebauteils, wie sie in Fig. 3, 5 und 6 gezeigt ist, weist ebenfalls an den Ecken Abstützflächen 104a auf, die sich auf dem Boden abstützen und dadurch das Haltebauteil 10 nach unten festlegen. Bei der vorangegangenen Montage der U-förmigen Leiterabschnitte 76 und des geraden Leiterabschnitts 88 werden die Zungen 78 bzw. 90 durch entsprechende Schächte, wie sie bei 106 angedeutet sind, nach oben in die Schaltplatine 16 hineingeführt.

In den Fign. 6 und 7 sind zwei Eisenteile 108, 110 dargestellt. 110 ist ein U-förmiges Teil und 108 eine Platte. Die Schenkel des U-förmigen Eisenteils 110 legen sich gegen zwei Außenflächen des Haltebauteils 14 an, welche einen runden Zapfen 112 aufweisen, die in eine entsprechende Öffnung 114 des U-förmigen Teils 110 eingreifen, wobei der Steg des U-förmigen Teils sich gegen die Oberseite des Haltebauteils 14 anlegt (Fig. 7), wie aus den Fign. 6 und 7 zu erkennen. Die Platte 108 weist mittig zwei Löcher 116 auf, die mit Führungs- und Haltestiften 118 am Boden 18 des Unterteils 10 zusammenwirken. Die Platte 108 weist in den Endbereichen zwei ovale Löcher 120 auf. Ferner ist an einem Rand eine halbkreisförmige Ausnehmung 122 geformt. Ausnehmung 122 und die Löcher 120 dienen für die Durchführung jeweils eines Schenkels der U-förmigen Leiterabschnitte 76. Platte 108 und U-förmiges Teil 110 bilden einen geschlossenen magnetischen Kreis, zur Abschirmung gegen elektromagnetische Felder. Die Leiterplatte 16 befindet sich dabei oberhalb des Steges des U-förmigen Teils 110.

Die Wandler 72 haben Anschlußleiter (nicht gezeigt), die durch eine Ausnehmung 17 der Leiterplatte 16 geführt und mittels Steckverbindung (nicht gezeigt) an die Leiterplatte 16 angeschlossen sind.

## Patentansprüche

1. Elektronischer Elektrizitätszähler, mit einem quaderförmigen Gehäuse (10), das alle Komponenten und Bauteile eines elektronischen Zählwerks enthält einschließlich einer Leiterplatte (16) mit Display und Stromsensoren (72) und das lösbar mit einer Zählerplattform (12) verbindbar ist, wobei die Zählerplattform (12) Anschlussmittel für die Phasen der Versorgungsleitungen enthält, und mit den Stromsensoren (72) zusammenwirkende Leiterabschnitte, die mit Kontakten der Zählerplattform (12) zusammenwirken, wenn das Gehäuse (10) auf die Plattform (12) aufgesetzt ist, und einem plombierbaren Plombierelement (59), das sich durch das Gehäuse (10) hindurch erstreckt und das Gehäuse (10) an der Plattform (12) verriegelt, **dadurch gekennzeichnet, dass** ein skelettartiges Haltebauteil (14) vorgesehen ist, das innerhalb des Gehäuses (10) festlegbar ist, an dem Haltebauteil (14) auf der dem Boden (18) des Gehäuses (10) zugewandten Seite drei Fassungen (66, 68, 70) angeformt sind, die Stromsensoren, vorzugsweise blockförmige Kapselungen von Stromwandlern (72), vorzugsweise klemmend, aufnehmen, das Haltebauteil (14) auf der dem Boden (18) des Gehäuses (10) zugewandten Seite ferner Schlitzabschnitte (80, 82, 84) zur Aufnahme von drei steifen Leiterschleifen aufweist, die durch jeweils einen Stromsensor (72) geführt sind und deren Enden sich durch Schlitze im Boden des Gehäuses (10) in Richtung Zählerplattform erstrecken und das Haltebauteil (14) auf der gegenüberliegenden Seite Rastmittel aufweist zur lösbaren Festlegung der Leiterplatte (16) parallel zum Boden (18) bzw. Deckenabschnitt des Gehäuses.

2. Elektrizitätszähler nach Anspruch 1, **dadurch gekennzeichnet, dass** an der Innenseite von gegenüberliegenden Seitenwänden (22, 26) des Gehäuses erste Rastmittel (94) angeformt sind und an gegenüberliegenden Enden des Haltebauteils (14) zweite Rastmittel (92) angeformt sind und erste und zweite Rastmittel das Haltebauteil (14) fest gegenüber dem Boden (18) und den Seitenwänden des Gehäuses (10) verriegeln.

3. Elektrizitätszähler nach Anspruch 2, **dadurch gekennzeichnet, dass** erste und zweite Rastmittel Rastvorsprünge sind, die einander hintergreifen.

4. Elektrizitätszähler nach Anspruch 2 oder 3, **dadurch gekennzeichnet, dass** in den gegenüberliegenden Seitenwänden (22, 26) Führungen (96) für Endabschnitte des Haltebauteils (14) angeformt sind.

5. Elektrizitätszähler nach einem der Ansprüche 1 bis 4, **dadurch gekennzeichnet, dass** U-förmige Leiterschleifen (76) vorgesehen sind, wobei ein Schenkel durch einen Stromsensor (72) erstreckt ist.

6. Elektrizitätszähler nach Anspruch 5, **dadurch gekennzeichnet, dass** am Boden (18) des Gehäuses (10) mindestens zwei beabstandete, vorzugsweise wandförmige Vorsprüngen (64, 118) geformt sind, die sich gegen die Unterseite der Stege der U-förmigen Leiterschleifen anlegen und die Stege der Leiterschleifen in Aufnahmeschlitzen des Haltebauteils (14) aufgenommen sind.

7. Elektrizitätszähler nach Anspruch 5 oder 6, **dadurch gekennzeichnet, dass** an die U-förmigen Leiterschleifen (76) eine Zunge (78) angeformt ist, die zwecks Spannungsmessung in Berührung mit einem Kontakt der Leiterplatte (16) steht.

8. Elektrizitätszähler nach Anspruch 7, **dadurch gekennzeichnet, dass** die Zunge (78) sich durch eine Öffnung (86) der Leiterplatte (16) erstreckt, in der eine Kontaktstelle vorgesehen ist.

9. Elektrizitätszähler nach Anspruch 7 oder 8, **dadurch gekennzeichnet, dass** die Zunge (78) sich durch einen Kanalabschnitt (106) des Haltebauteils (14) erstreckt.

10. Elektrizitätszähler nach einem der Ansprüche 1 bis 10, **dadurch gekennzeichnet, dass** das Haltebauteil (14) auf der dem Boden (18) abgewandten Seite mindestens eine Abstützfläche (102) für die Leiterplatte (16) aufweist und das Haltebauteil (14) an gegenüberliegenden Enden jeweils einen flexiblen Arm (98) aufweist, an dessen freiem Ende eine Rastnase (100) geformt ist, die die Leiterplatte (16) rastend übergreift, wenn sie auf der Abstützfläche (102) abgelegt ist.

11. Elektrizitätszähler nach Anspruch 10, **dadurch gekennzeichnet, dass** die Leiterplatte (16) an gegenüberliegenden Enden Aussparungen (104) aufweist und der Arm (98) an den passend von der Aussparung (104) aufgenommen ist, wenn die Rastnase (100) die Schaltplatine (16) übergreift.

12. Elektrizitätszähler nach einem der Ansprüche 1 bis 11, **dadurch gekennzeichnet, dass** das Haltebauteil (14) Festlegemittel für eine Abschirmung der Stromwandler (92) gegen magnetische Störfelder aufweist.

13. Elektrizitätszähler nach Anspruch 12, **dadurch gekennzeichnet, dass** die magnetische Abschirmung aus einem U-förmigen und einem plattenförmigen Teil (110, 108) besteht, wobei das plattenförmige Teil (108) gegen die Schenkel des U-förmigen Teils (110) angelegt wird, der Steg des U-förmigen Teils (110) zwischen der Leiterplatte (16) und dem Haltebauteil (14) liegt und die Schenkel des U-förmigen Teils (110) jeweils ein Loch (114) aufweist, das mit einem seitlichen runden Zapfen (112) des Haltebauteils (14) zusammenwirkt und das plattenförmige Teil (108) ebenfalls zwei Löcher (116) aufweist, die mit Vorsprüngen (118) am Boden (18) des Gehäuses (10) zusammenwirken.

14. Elektrizitätszähler nach einem der Ansprüche 5 bis 13, **dadurch gekennzeichnet, dass** am Boden (18) des Gehäuses (10) pfostenartige Erhebungen (60, 62) geformt sind mit einem schlitzförmigen Durchgangskanal, der jeweils einen Schenkel der U-förmigen Leiterschleife (76) annähernd passend aufnimmt.

## Claims

1. An electronic electricity meter, with a cubelike housing (10) which contains all components and structural elements of an electronic meter, including a circuit board (16) with display and current sensors (72), and which is detachably connected with a meter platform (12), wherein the meter platform (12) contains connection means for the phases of the supply lines, and line sections, which act together with the contacts of the counter platform (12), and which act together with current sensors (72) when the housing (10) is attached on the platform (12), and with a leaded anti-tamper seal element (59), which extends though the housing (10) and secures the housing (10) to the platform (12), **characterized in that** a skeletal-like retaining element (14) is provided, which can be fixed within the housing (10), that on the retaining element (14) on the side facing the bottom (18) of the housing (10) three sockets (66, 68, 70) are formed which receive, preferably clamped, current sensors, preferably block-shaped enclosures of current converters (72), that the retaining element (14) on the side facing on the bottom (18) of the housing (10) further has slot sections (80, 82, 84) for receiving three rigid conductor loops, which are lead, in each case, through a current sensor (72) and whose ends extend through slots in the bottom of the housing (10) in the direction of the meter platform, and that the retaining element (14) has locking means on the opposing side for releasable fixing of the circuit board (16) parallel to the bottom (18) or cover section of the housing.

2. The electricity meter according to claim 1, **characterized in that** first locking means (94) are formed on the inner side of opposing side walls (22, 26) of the housing, and second locking means (92) are formed on opposing ends of the retaining element (14), and first and second locking means fixedly secure the retaining element (14) relative to the bottom (18) and the side walls of the housing (10).

3. The electricity meter according to Claim 2, **characterized in that** the first and second locking means are locking projections, which engage behind each other.

4. The electricity meter according to Claim 2 or 3, **characterized in that** guides (96) are formed in the opposing side walls (22, 26) for end sections of the retaining element (14).

5. The electricity meter according to one of the claims 1 to 4, **characterized in that** U-shaped current loops (76) are provided, wherein a limb extends through a current sensor (72).

6. The electricity meter according to claim 5, **characterized in that** on the bottom (18) of the housing (10) at least two distanced, preferably wall-shaped projections (64, 118) are formed, which lie against the lower side of the webs of the U-shaped current loops, and that the webs of the current loops are held in receiving slots of the retaining element (14).

7. The electricity meter according to Claim 5 or 6, **characterized in that** formed onto the U-shaped current loops (76) is a tongue (78) which for the purpose of voltage measurement stands in contact with a contact of the circuit board (16).

8. The electricity meter according to claim 7, **characterized in that** the tongue (78) extends through an opening (86) of the circuit board (16), in which a contact area is provided.

9. The electricity meter according to claim 7 or 8, **characterized in that** the tongue (78) extends through a channel section (106) of the retaining element (14).

10. The electricity meter according to one of the claims I to 10, **characterized in that** the retaining element (14) on the side facing the bottom (18) has at least one support face (102) for the circuit board (16), and that the retaining element (14) has on opposing ends, in each case, a flexible arm (98), at whose free end a locking tab (100) is formed, which lockingly overlaps the circuit board (16), when it is placed on the support face (102).

11. The electricity meter according to claim 10, **characterized in that** the circuit board (16) has recesses (104) on opposing ends, and the arm (98) is received fittingly by the recess (104), when the locking tab (100) overlaps the printed circuit board (16).

12. The electricity meter according to one of the claims I to 11, **characterized in that** the retaining element (14) has a fixing means for a shielding of the current converters (92) against magnetic noise fields.

13. The electricity meter according to claim 12, **characterized in that** the magnetic shielding is composed of a U-shaped and a plate-shaped part (110, 108), wherein the plate-shaped part (108) abuts against the limbs of the U-shaped part (110), the web of the U-shaped part (110) lies between the circuit board (16) and the retaining element (14), and the limbs of the U-shaped part (110) in each case have a hole (114), which acts together with a round peg (112) on the side of the retaining element (14), and the plate-shaped part (108) also has two holes (116), which act together with projections (118) on the bottom (18) of the housing (10).

14. The electricity meter according to one of the claims 5 to 13, **characterized in that** post-like elevations (60, 62) are formed on the bottom (18) of the housing (10), with a slot-shaped through channel, which in each case receives approximately fittingly a limb of the U-shaped current loop (76).

## Revendications

1. Compteur d'électricité électronique, avec un boîtier de forme rectangulaire (10) qui comprend tous les composants et éléments de construction d'un compteur électronique y compris un circuit imprimé (16) avec affichage et capteurs de courant (72) et qui peut être raccordé de manière amovible à une plate-forme de compteur (12), la plate-forme de compteur (12) comprenant des moyens de connexion pour les phases des lignes d'alimentations, et des sections de conducteur coopérant avec les capteurs de courant (72) qui coopèrent avec des contacts de la plate-forme de compteur (12) lorsque le boîtier (10) est placé sur la plate-forme (12), et avec un élément de plombage (59) plombable qui s'étend à travers le boîtier (10) et verrouille le boîtier (10) sur la plate-forme (12), **caractérisé en ce qu'**un élément de support (14) squelettique est prévu qui peut être fixé à l'intérieur du boîtier (10), trois supports (66, 68, 70) sont formés dans l'élément de support (14) sur le côté faisant face au fond (18) du boîtier (10) qui reçoivent de préférence en les serrant des capteurs de courant, de préférence des enveloppes de transformateurs de courant (72) en forme de bloc, l'élément de support (14) présente en outre sur le côté faisant face au fond (18) du boîtier (10) des sections de fente (80, 82, 84) pour la réception de trois boucles de conducteur rigides qui sont guidées respectivement à travers un capteur de courant (72) et dont les extrémités s'étendent à travers des fentes dans le fond du boîtier (10) en direction de la plate-forme de compteur et l'élément de support (14) présente sur le côté opposé des moyens d'encliquetage pour la fixation amovible du circuit imprimé (16) parallèlement au fond (18) ou à la section de couvercle du boîtier.

2. Compteur d'électricité selon la revendication 1, **caractérisé en ce que** des premiers moyens d'encliquetage (94) sont formés du côté intérieur de parois latérales (22, 26) opposées du boîtier et des seconds moyens d'encliquetage (92) sont formés à des extrémités opposées de l'élément de support (14) et les premiers et seconds moyens d'encliquetage verrouillent l'élément de support (14) fixement par rapport au fond (18) et aux parois latérales du boîtier (10).

3. Compteur d'électricité selon la revendication 2, **caractérisé en ce que** les premiers et seconds moyens d'encliquetage sont des saillies d'encliquetage qui engrènent les unes dans les autres.

4. Compteur d'électricité selon la revendication 2 ou 3, **caractérisé en ce que** des guides (96) pour des sections d'extrémités de l'élément de support (14) sont formés dans les parois latérales (22, 26) opposées.

5. Compteur d'électricité selon l'une quelconque des revendications 1 à 4, **caractérisé en ce que** des boucles de conducteur (76) en forme de U sont prévues, une branche étant étendue à travers un capteur de courant (72).

6. Compteur d'électricité selon la revendication 5, **caractérisé en ce qu'**au fond (18) du boîtier (10) au moins deux saillies (64, 118) espacées, de préférence en forme de paroi sont formées qui s'appuient sur le côté inférieur des traverses des boucles de conducteur en forme de U et que les traverses des boucles de conducteur sont reçues dans des fentes de réception de l'élément de support (14).

7. Compteur d'électricité selon la revendication 5 ou 6, **caractérisé en ce que**, sur les boucles de conducteur (76) en forme de U, une lame (78) est formée qui, en vue de la mesure de tension, est en contact avec un contact du circuit imprimé (16).

8. Compteur d'électricité selon la revendication 7, **caractérisé en ce que** la lame (78) s'étend à travers une ouverture (86) du circuit imprimé (16), dans lequel un point de contact est prévu.

9. Compteur d'électricité selon la revendication 7 ou 8, **caractérisé en ce que** la lame (78) s'étend à travers une section de canal (106) de l'élément de support (14).

10. Compteur d'électricité selon l'une quelconque des revendications 1 à 10, **caractérisé en ce que** l'élément de support (14) sur le côté opposé au fond (18) présente au moins une face d'appui (102) pour le circuit imprimé (16) et l'élément de support (14) présente à des extrémités opposées respectivement un bras flexible (98), à l'extrémité libre duquel un bec d'encliquetage (100) est formé qui entre en prise par encliquetage avec le circuit imprimé (16), lorsqu'il est déposé sur la face d'appui (102).

11. Compteur d'électricité selon la revendication 10, **caractérisé en ce que** le circuit imprimé (16) présente des évidements (104) à des extrémités opposées et le bras (98) est reçu de manière ajustée par l'évidement (104), lorsque le bec d'encliquetage (100) entre en prise avec le circuit imprimé (16).

12. Compteur d'électricité selon l'une quelconque des revendications 1 à 11, **caractérisé en ce que** l'élément de support (14) présente des moyens de fixation pour un blindage des transformateurs de courant (92) contre des champs magnétiques perturbateurs.

13. Compteur d'électricité selon la revendication 12, **caractérisé en ce que** le blindage magnétique consiste en une pièce en forme de U et une pièce en forme de plaque (110, 108), la pièce en forme de plaque (108) étant appuyé sur les côtés de la pièce en forme de U (110), la traverse de la pièce en forme de U (110) étant située entre le circuit imprimé (16) et l'élément de support (14) et les côtés de la pièce en forme de U (110) présentant chacun un trou (114) qui coopère avec un tenon rond latéral (112) de l'élément de support (14) et la pièce en forme de plaque (108) présente également deux trous (116) qui coopèrent avec des saillies (118) au fond (18) du boîtier (10).

14. Compteur d'électricité selon l'une quelconque des revendications 5 à 13, **caractérisé en ce que** des élévations de type poteau (60, 62) sont formés sur le fond (18) du boîtier (10) avec un canal de passage en forme de fente qui reçoit respectivement une branche de la boucle de conducteur (76) en forme de U de manière approximativement ajustée.
